# EUROPÄISCHE PATENTSCHRIFT

(11) **EP 1 190 324 B1**
(45) Veröffentlichungstag und Bekanntmachung des Hinweises auf die Patenterteilung: **06.08.2003**
(21) Anmeldenummer: 00929490.1
(22) Anmeldetag: 04.05.2000
(51) Int. Cl.: G06F 11/20

(54) **VERFAHREN ZUM GESICHERTEN SCHREIBEN EINES ZEIGERS FÜR EINEN RINGSPEICHER**
PROCESS FOR THE SECURE WRITING OF A POINTER FOR A CIRCULAR MEMORY
PROCEDE D'ECRITURE SURE D'UN POINTEUR POUR UNE MEMOIRE CIRCULAIRE

(30) Priorität: 07.05.1999 DE 19921232
(43) Veröffentlichungstag der Anmeldung: 27.03.2002
(73) Patentinhaber: Giesecke & Devrient GmbH, 81677 München (DE)
(72) Erfinder: WEISS, Dieter, D-81677 München (DE)
(74) Vertreter: Klunker . Schmitt-Nilson . Hirsch
(86) Internationale Anmeldenummer: EP0003990
(87) Internationale Veröffentlichungsnummer: WO00068794

(56) Entgegenhaltungen:
- EP-A- 0 353 435
- US-A- 4 566 106
- US-A- 5 758 330

## Beschreibung

Die Erfindung betrifft ein Verfahren zum gesicherten Schreiben eines Zeigers für einen Ringspeicher, außerdem einen solchen Ringspeicher mit einem Zeiger-Speicherplatz und eine Chipkarte, die einen solchen Ringspeicher enthält.

Ringspeicher oder zyklische Speicher, deren Inhalt auch als zyklische Datei oder dergleichen bezeichnet wird, können als virtuelle Speicher oder Hardware-Speicher ausgebildet sein. Ein Ringspeicher ist insbesondere eine typische Organisationsform für einen elektrisch löschbaren, programmierbaren Festspeicher (EEPROM), auf den sich die vorliegende Erfindung sowie die Darstellung der Ausführungsbeispiele der Erfindung speziell bezieht, obschon die Erfindung bei Ringspeichern allgemein Anwendung finden kann.

Ein Ringspeicher enthält eine gegebene Anzahl von Speicherplätzen, wobei die zyklische Datei in dem Ringspeicher eine Reihe von Datensätzen (records) enthält, von denen jeweils ein Datensatz in einem Speicherplatz gespeichert ist. Die Datensätze werden zyklisch nacheinander in den Ringspeicher eingeschrieben, mit der Maßgabe, daß zum Einschreiben eines neuen Datensatzes der jeweils älteste Datensatz überschrieben wird. Bei einer fortlaufenden Numerierung 1, 2,... n der Speicherplätze des Ringspeichers schließt sich der Speicherplatz "1" zyklisch an den Speicherplatz "n" an. Der jeweils "aktuelle" oder jüngste Datensatz befindet sich in einem Speicherplatz, der durch einen Zeiger (pointer) adressiert wird. Für das Einschreiben aufeinanderfolgender Datensätze wird der Zeiger jeweils um eine Speicherplatzadresse - zyklisch - erhöht.

Um die der vorliegenden Erfindung zugrundeliegende Problematik zu verdeutlichen, soll hier das Einschreiben eines neuen Datensatzes in einen vorbestimmten Speicherplatz eines als EEPROM ausgebildeten Ringspeichers näher betrachtet werden. Solche EEPROMs finden insbesondere in Chipkarten Verwendung, so daß sich die hier vorliegende Problematik auch insbesondere auf Chipkarten bezieht.

Um einen neuen Datensatz in einen vorbestimmten Speicherplatz einzuschreiben, insbesondere in den Speicherplatz, der den ältesten Datensatz innerhalb des Ringspeichers aufnimmt, muß zunächst der Inhalt dieses vorbestimmten Speicherplatzes gelöscht werden, bevor die neuen Daten eingeschrieben werden können. Dies geschieht in üblicher Weise so, daß schrittweise nacheinander jeweils der Zeiger erhöht und der jeweils neue Datensatz eingeschrieben wird. Wenn es nun etwa aufgrund eines Stromausfalls zu einer Unterbrechung des Schreibvorgangs kommt, geht möglicherweise die Information des neuen Datensatzes verloren, darüber hinaus auch die Zeigerinformation, was noch gravierender ist, da dann keine Information über die Stelle vorliegt, in der der nächste Datensatz abzuspeichern ist Ein weiteres Problem, welches die Zeigerinformation betrifft, ist ein mögliches Verfälschen des Zeigers, beispielsweise dann, wenn der Zeiger aktualisiert wird.

Im Stand der Technik gibt es eine Reihe von Vorschlägen, wie bei einem Ringspeicher derartige Fehler vermieden werden können. Die FR-A-2 699 704 beschreibt ein Verfahren zum Aktualisieren von Daten in einem EEPROM, bei dem zu jedem einzelnen Datensatz ein mehrstelliges Flag gespeichert wird. Soll an die Stelle des "alten" Datensatzes ein neuer Datensatz geschrieben werden, so wird zunächst der alte Datensatz einschließlich seines Flags gelöscht. An die Stelle des alten Datensatzes wird der neue Datensatz geschrieben, das dazugehörige Flag wird auf einen Wert eingestellt, der angibt, daß gerade eine Daten-Aktualisierung stattfindet.

Dann wird das Flag des bisherigen aktuellen Datensatzes auf "alt" eingestellt, und das die laufende Aktualisierung anzeigende Flag des neuen Datensatzes wird auf "aktuell" eingestellt. Dieses Verfahren ist arbeitsaufwendig und speicherplatzintensiv. Findet bei der Flag-Umstellung nach dem Abspeichern des neuen Datensatzes eine Unterbrechung statt, gibt es keinen aktuellen Datensatz, der Zustand ist also unbestimmt.

Aus der EP-A-0 398 545 ist ein Ringspeicher bekannt, bei dem zu jedem Datensatz ein aus einem Bit gebildetes Flag vorhanden ist Beim Einschreiben eines neuen Datensatzes in den Ringspeicher erfolgt nach dem Schreibvorgang ein Markieren des neuen Datensatzes mit einem einen aktuellen Datensatz kennzeichnenden Flag, zum Beispiel "1". Im Anschluß daran wird das zu dem bisher aktuellen Datensatz gehörige Flag "1" auf "0" gesetzt In diesem Zwischenstadium gibt es also zwei Flags mit dem Wert "1". Dieses Dilemma des unbestimmten Zeiger-Flags für den jeweils aktuellen Datensatz wird mit Hilfe der Konvention zu überwinden versucht, gemäß der bei mehreren Flags mit dem Wert "1" stets das "obere" Flag gültig sein soll. Da aus Einzel-Bits bestehende Flags ohnehin besonders anfällig für Schreibfehler sind, kann es bei der Aktualisierung des Zeiger-Flags sehr leicht zu fehlerhaften Zeigerdaten kommen.

Aus der DE-A-196 50 993 ist ein Ringspeicher bekannt, bei dem ein von außerhalb der Schnittstelle des Ringspeichers nicht zu erkennender zusätzlicher Speicherplatz vorhanden ist. Bei einem Schreibvorgang wird immer der jeweils älteste Datensatz überschrieben, gefolgt von einem Aktualisieren des Zeigers in der Weise, daß der Zeiger dann auf den neuen Datenwert zeigt. Bei einer Störung geht dann nur die Information des ältesten Datensatzes verloren, dies ist aber von außerhalb der Schnittstelle nicht erkennbar. Auch bei diesem Speichersystem besteht die Möglichkeit, das durch fehlerhaftes Schreiben des Zeigers falsche Zeigerdaten entstehen.

Der Erfindung liegt die Aufgabe zugrunde, ein Verfahren anzugeben, welches ein sicheres Schreiben des Zeigers ermöglicht. Außerdem soll ein Ringspeicher in Verbindung mit einem sicheren Zeiger angegeben werden.

Zur Lösung dieser Aufgabe gemäß Anspruch 1 wird statt eines einzigen Zeigers noch ein weiterer, redundanter Zeiger abgespeichert. In einer besonders bevorzugten Ausführungsform erfolgt das Schreiben des ersten und des zweiten, redundanten Zeigers separat, insbesondere zeitlich gestaffelt, so daß bei einer möglicherweise eintretenden Störung im Verlauf des Schreibens der beiden Zeiger mindestens ein Zeiger die korrekte Zeigerinformation beinhaltet. Als weiteres erfindungsgemäßes Merkmal besitzen der erste und der zweite Zeiger jeweils einen Prüfwert. Anhand dieses Prüfwerts läßt sich ein fehlerhafter Zeiger erkennen. Ein Korrekturvorgang ist möglich durch lediglich einen einzigen Schreibvorgang, das heißt durch ein Kopieren des intakten Zeigers.

Das Aktualisieren des Zeigers erfolgt bevorzugt in einem ersten Schritt unter gleichzeitigem Bilden des zu dem ersten Zeiger gehörigen Prüfwerts. Nach Vergleich des ersten, neuen Zeigers mit dem zweiten Zeiger wird gegebenenfalls der zweite Zeiger als Kopie des ersten Zeigers hergestellt.

Wenn bei dem Schreiben des ersten und des zweiten Zeigers eine Störung auftritt, beispielsweise eine Stromunterbrechung beim Beschreiben eines EEPROMs, ist möglicherweise der erste Zeiger bereits aktualisiert, während der zweite Zeiger noch den alten Wert hat. Je nach Zeitpunkt der Störung und nach Art des Fehlers kann nun entweder aus dem zweiten Zeiger die ursprüngliche Information des ersten Zeigers rückgewonnen werden, oder es kann der zweite Zeiger entsprechend dem ersten Zeiger nachträglich aktualisiert werden.

Die Verwendung eines zusätzlichen, redundanten Zeigers schafft insbesondere dann, wenn die beiden Zeiger zeitlich getrennt geschrieben werden, einen sicheren Schutz gegen die Entstehung fehlerhafter Zeigerdaten. Außerdem wird hierdurch die Möglichkeit gegeben, in jeder Situation den jeweils gewünschten Zeigerinhalt zu rekonstruieren, insbesondere bei Stromausfällen im Zeitpunkt der Zeigeraktualisierung. Der zu jedem Zeiger gehörige Prüfwert besteht vorzugsweise aus dem Komplement des Codes der betreffenden Speicherplatznummer. Der Zeiger besteht aus der Adresse oder Nummer des aktuellen Speicherplatzes, der Prüfwert wird durch Bildung des Komplements erhalten.

In einer speziellen Ausgestaltung ist vorgesehen, daß ein Zeiger aus jeweils zwei Bytes besteht, wobei das erste Byte (8 Bits) den Speicherplatz-Code in zwei Hexadezimalzahlen umfassender Form enthält, und das zweite Byte des Zeigers den entsprechenden komplementären Hexadezimal-Code enthält.

Durch die bevorzugten Maßnahmen gemäß der Erfindung wird eine Mehrfach-Redundanz geschaffen, die praktisch zu beliebiger Zeit eine Fehlererkennung und -korrektur gestattet. Insbesondere wird im Fall einer Störung in Form einer Stromunterbrechung die Möglichkeit geschaffen, den Zeigerinhalt zu rekonstruieren.

Das erfindungsgemäße Verfahren schafft mit einem geringem Mehraufwand an Speicherplatz für den zweiten Zeiger und die Prüfwerte und jeweils einen zusätzlichen Schreibzyklus für das Schreiben des zweiten Zeigers die Möglichkeit, eine nahezu vollkommene Sicherung der Daten zu erreichen. Besonders bevorzugt wird von diesen Vorteilen bei einer Chipkarte Gebrauch gemacht, die in aller Regel sensible Daten enthält, die einer besonderen Sicherung bedürfen.

In Verbindung mit den oben genannten Maßnahmen wird bevorzugt auch von der Maßnahme Gebrauch gemacht, den zyklischen Speicher um einen Speicherplatz zu erweitern, wobei dieser zusätzliche Speicherplatz allerdings nach außen, das heißt an der Schnittstelle des Ringspeichers, nicht in Erscheinung tritt. Der jeweils neu einzuschreibende Datensatz wird dann an die Stelle des jeweils ältesten Datensatzes geschrieben, so daß bei einer Störung nur der älteste Datensatz verlorengeht, dies aber nach außen nicht auffällig wird, da von außen nur die vorbestimmte Anzahl von Speicherplätzen ohne den zusätzlichen Speicherplatz vorhanden ist.

Im folgenden werden Ausführungsbeispiele der Erfindung anhand der Zeichnungen näher erläutert. Es zeigen:
Figur 1 eine schematische Ansicht des Speicherplatzes für einen ersten Zeiger und einen zweiten Zeiger eines Ringspeichers;
Figur 2 einen Ringspeicher mit einer vorgegebenen Anzahl von Speicherplätzen, wobei drei Phasen eines Schreibvorgangs für einen neuen Datensatz veranschaulicht sind, jeweils in Verbindung mit einem ersten und einem zweiten Zeiger-Speicherplatz;
Figur 3 ein Flußdiagramm, welches den Vorgang des Aktualisierens eines ersten und eines zweiten Zeigers einschließlich Paritätsprüfung veranschaulicht; und
Figur 4 drei aufeinanderfolgende Phasen beim Schreiben eines ersten und eines zweiten Zeigers.

Die im folgenden zu beschreibenden Ausführungsbeispiele beziehen sich speziell auf ein EEPROM mit einer Ringspeicher-Verwaltung. Zum Einschreiben eines neuen Datensatzes in den Ringspeicher werden in an sich bekannter Weise Stromsignale in den EEPROM eingespeist, so daß diese den Zustand des von dem Zeiger adressierten Speicherplatzes verändern. Die Erfindung ist aber auch in Verbindung mit anderen Ringspeichern einsetzbar, auch in Verbindung mit virtuellen Ringspeichern.

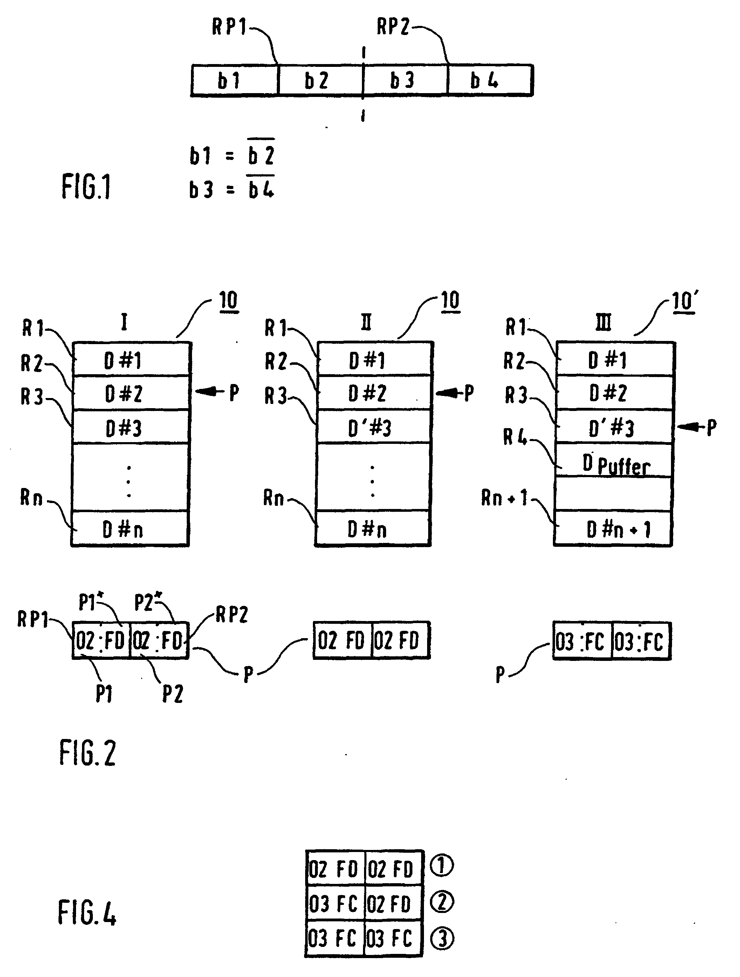

Es soll zunächst auf Figur 2 Bezug genommen werden, in der links ein Ringspeicher 10 mit der Bezeichnung I dargestellt ist, wobei I für die erste Phase eines Schreibvorgangs steht.

Der Ringspeicher 10 enthält n Speicherplätze R1, R2, R3, ... Rn. In diesen Speicherplätzen befindet sich jeweils ein Datensatz, der in Figur 2 angelehnt an die Numerierung der Speicherplätze mit D#1, D#2 ... D#n bezeichnet ist. Ein Zeiger (pointer) P zeigt auf den jeweils aktuellen, bei einem zyklischen Schreibvorgang jüngsten Datensatz, im vorliegenden Beispiel bei 1 in Figur 2 auf den Datensatz D#2 in dem Speicherplatz R2.

Unterhalb des Ringspeichers 10 links in Figur 2 ist der Zeiger P schematisch dargestellt. Der Zeiger P enthält einen ersten Zeiger, der in einem ersten Zeiger-Speicherplatz RP1 abgespeichert ist, außerdem einen dazu redundanten, zweiten Zeiger, der in einem weiteren Zeiger-Speicherplatz RP2 abgespeichert ist.

Der erste Zeiger besteht aus dem eigentlichen Zeigerelement, in Form des Codes der Speicherplatzadresse, hier mit P1 bezeichnet. Weiterer Bestandteil des ersten Zeigers ist als Prüfwert ein zu P1 komplementärer Datenwert P1*. Der zweite Zeiger besteht aus einer Kopie des ersten Zeigers, wobei P2 wiederum durch den Code der Speicherplatzadresse gebildet ist und P2* das Komplement von P2 ist.

Im vorliegenden Fall besteht eine Speicherplatzadresse aus einem zweistelligen Hexadezimalcode. P1 hat den Wert "02", der dazu komplementäre Wert lautet FD (die komplementären Hexadezimal- oder Sedezimalzahlen von 0,1, 2,3,... 9, A, B, C, D, F lauten F, E, D, 3,2,1 bzw. 0). Figur 1 zeigt schematisch die Byte-Organisation des Zeigers P in den beiden Zeiger-Speicherplätzen RP1 und RP2. Der erste Zeiger-Speicherplatz enthält die beiden Bytes b1 und b2, wobei b1 das Komplement von b2 ist, und umgekehrt. In dem zweiten Zeiger-Speicherplatz RP2 sind die beiden Bytes b3 und b4 enthalten, wobei wiederum die Beziehung gilt, daß b3 das Komplement von b4 ist, und umgekehrt.

Anhand der in Figur 2 dargestellten drei Phasen I, II und III soll im folgenden erläutert werden, wie ein neuer Datensatz an die Stelle des ältesten Datensatzes geschrieben wird. Links in Figur 2 zeigt der Zeiger P auf den Speicherplatz R2, der den Datensatz D#2 enthält. Aufgrund der zyklischen Struktur des Ringspeichers 10 ist dann definitionsgemäß der älteste Datensatz in dem anschließenden Speicherplatz R3 enthalten. Der dort noch abgespeicherte Datensatz D#3 soll überschrieben werden. Hierzu wird zunächst der Inhalt des Speicherplatzes R3 gelöscht, und dann wird der neue Datensatz D'#3 eingeschrieben, wie in der Mitte der Figur 2 unter II gezeigt ist. Nach abgeschlossenem Schreibvorgang für den neuen Datensatz D'#3 wird der Zeiger P aktualisiert, damit er dann auf den jüngsten aktuellen Datensatz D'#3 zeigt, wie rechts in Figur 2 unter III angedeutet ist.

Unten rechts in Figur 2 ist der Inhalt der beiden Speicherplätze für den ersten und den zweiten Zeiger dargestellt. Wie man sieht, zeigt der erste Zeiger (P1 = 03; P1* = FC) auf den dritten Speicherplatz R3 des Ringspeichers.

Rechts in Figur 2 ist der Ringspeicher mit 10' bezeichnet, um die Besonderheit einer Ausführungsform der Erfindung zu verdeutlichen. Gemäß dieser besonderen Ausführungsform ist der Ringspeicher 10' gegenüber den übrigen in Figur 2 dargestellten Versionen des Ringspeichers um einen Speicherplatz erweitert, enthält also insgesamt R(n +1) Speicherplätze. Von außerhalb der Schnittstelle des Ringspeichers betrachtet, enthält der Ringspeicher 10' aber nach wie vor n Speicherplätze. Der zum Einschreiben des jeweils nächsten Datensatzes verwendete Speicherplatz, rechts in Figur 2, also der Speicherplatz R4, enthält einen als Schreibpuffer dienenden Datensatz, das heißt den ältesten Datensatz, der von außerhalb des Ringspeichers nicht zum Lesen zugänglich ist. Bei einem Schreibvorgang, wie er oben erläutert wurde, wird ein neuer Datensatz in diesen Speicherplatz eingeschrieben. Im Fall einer Störung gehen nur diese redundanten Daten als älteste Daten verloren.

Wie durch die unten in Figur 2 nebeneinander dargestellten Zeiger, jeweils bestehend aus einem ersten Zeiger P1, P1* und einem zweiten Zeiger P2, P2*, ersichtlich ist, erfolgt das Aktualisieren des Zeigers erst nach dem erfolgten Einschreiben des jeweils jüngsten Datensatzes, in der Mitte in Figur 2 also des Datensatzes D'#3.

Wenn es beim Schreiben, das heißt beim Aktualisieren des Zeigers zu einer Störung, insbesondere zu einem Stromausfall kommt, kann wahlweise der alte oder der neue Zeiger rekonstruiert werden. Dies ist in Figur 4 sdiematisch dargestellt.

Figur 4 zeigt untereinander drei Phasen beim Aktualisieren des kompletten Zeigers. Im Stadium "1" liegt der alte Zustand des Zeigers vor. Im Stadium "2" ist der erste Zeiger P1, P1* bereits erhöht um eine Speicherplatzadresse, steht also auf "03" bzw. "FC". In diesem Stadium entspricht der Inhalt des zweiten Zeigers noch dem alten Wert. Im dritten Stadium "3" wird dann in den Zeiger-Speicherplatz für den zweiten Zeiger der Datenwert des ersten Zeigers P1, P1* kopiert.

Kommt es im Stadium "2" zu einer Störung, so läßt sich aus dem ersten Zeiger P1, P1* der zweite Zeiger als neuer zweiter Zeiger gewinnen. Alternativ kann aus dem zweiten Zeiger P2, P2 der alte erste Zeiger zurückgewonnen werden.

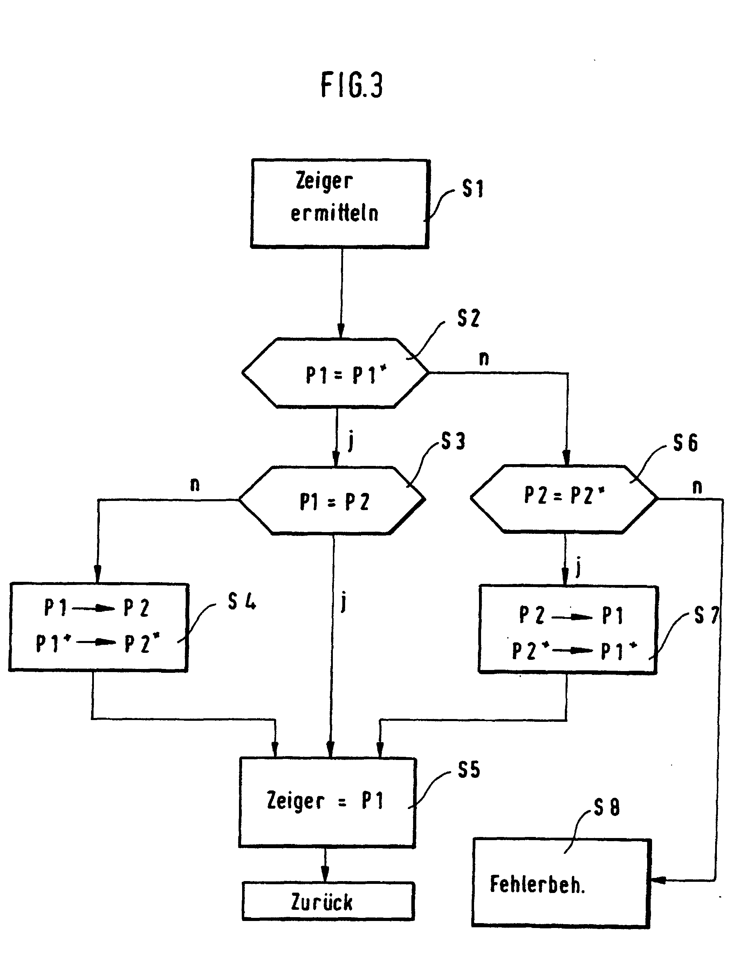

Figur 3 zeigt anhand eines Ablaufdiagramms das Verfahren zur Ermittlung des aktuellen Zeigerwertes und seiner Überprüfung auf Richtigkeit. Im Schritt S1 wird die Ermittlung/Überprüfung initiiert.

Im nachfolgenden Schritt S2 erfolgt eine Abfrage, ob der Zeiger P1 mit dessen Prüfwert, das heißt im vorliegenden Fall dessen Komplement-Code P1* übereinstimmt. Bei Übereinstimmung erfolgt im Schritt S3 ein Vergleich des ersten mit dem zweiten Zeiger. Bei Nichtübereinstimmung wird im Schritt S4 der erste Zeiger komplett in den zweiten Zeiger einkopiert.

In dem an diesen Schritt S4 anschließenden Schritt S5 wird der zyklische Zeiger, der zum tatsächlichen Adressieren des betreffenden Speicherplatzes verwendet wird, auf P1 gesetzt. Das gleiche geschieht, falls sich bei dem Vergleich im Schritt S3 ergibt, daß die beiden Zeiger P1 und P2 übereinstimmen.

Im Fall eines Paritätsfehlers im Vergleichsschritt S2 wird eine entsprechende Paritätsabfrage für den zweiten Zeiger durchgeführt, Schritt S6. Ist für den zweiten Zeiger P2, P2* die Parität erfüllt, so wird in einem Schritt S7 der erste Zeiger korrigiert, indem der zweite Zeiger P2 einschließlich des Prüfwerts P2* in den ersten Zeiger kopiert wird. Dann wiederum wird der Code für P1 zum Adressieren des betreffenden Speicherplatzes verwendet.

Für den Fall, daß in Schritt S6 festgestellt wird, daß auch der zweite Zeiger P2 keinen korrekten Wert enthält, wird in Schritt S8 eine Fehlerbearbeitungsroutine angestoßen.

Das oben beschriebene Verfahren zur Ermittlung und Überprüfung des Zeigerwertes eines ersten und eines zweiten Zeigers, die jeweils als Prüfwert den komplementären oder inversen Code enthalten, wird in Verbindung mit dem in Figur 2 skizzierten Ringspeicher 10 bevorzugt in Form eines EEPROM in Chipkarten eingesetzt.

## Patentansprüche

1. Verfahren zum gesicherten Schreiben eines Zeigers (P) für in einzelnen Speicherplätzen (R1, R2, ...) eines Ringspeichers (10; 10') enthaltene Datensätze, bei dem
a) zusätzlich zu einem ersten Zeiger (P1, P1*) ein zweiter, zu dem ersten Zeiger redundanter Zeiger (P2, P2*) geschrieben wird; und
b) sowohl der erste als auch der zweite Zeiger um einen Prüfwert erweitert wird.

2. Verfahren nach Anspruch 1, **dadurch gekennzeichnet, daß** der erste Zeiger (P1, P1*) und der zweite Zeiger (P2, P2*) getrennt voneinander, insbesondere zeitlich gestaffelt, geschrieben werden.

3. Verfahren nach Anspruch 1 oder 2, **dadurch gekennzeichnet, daß** eine Ermittlung bzw. Überprüfung des aktuellen Zeigers folgende Schritte umfaßt:
a) Prüfen des ersten Zeigers (P1) anhand des Prüfwertes (P1*) (S2),
b) Vergleichen des ersten Zeigers mit dem zweiten Zeiger (S3), wenn der erste Zeiger (P1) korrekt ist,
c) bei Nichtübereinstimmung der beiden Zeiger beim Vergleich gemäß Schritt b) wird der erste Zeiger kopiert, um den neuen zweiten Zeiger zu erhalten,
d) Prüfen des zweiten Zeigers (P2) anhand des Prüfwertes (P2*) (S6), wenn der erste Zeiger (P1) nicht korrekt ist,
e) Überschreiben des ersten Zeigers (P1,P1*) mit dem Wert des Zeigers (P2,P2*) (57), wenn der zweite Zeiger gemäß d) korrekt ist.

4. Verfahren zum Verwalten eines Ringspeichers (10;10') unter Verwendung des Verfahrens nach einem der Ansprüche 1 bis 3, **dadurch gekennzeichnet, daß** zum Einschreiben eines neuen Datensatzes (D'#3) in einen vorbestimmten Speicherplatz (R3), der zyklisch an den von dem Zeiger (P) bezeichneten Speicherplatz (R2) anschließt, der neue Datensatz in den vorbestimmten Speicherplatz (R3) eingeschrieben und anschließend ein aktualisierter Zeiger geschrieben wird.

5. Verfahren nach Anspruch 4, **dadurch gekennzeichnet, daß** vor dem Einschreiben des neuen Datensatzes (D'#3) in die vorbestimmte Speicherzelle deren Inhalt gelöscht wird.

6. Verfahren nach Anspruch 4 oder 5, **dadurch gekennzeichnet, daß** der vorbestimmte Speicherplatz den ältesten Datensatz in dem Ringspeicher (10') enthält und als Schreibpuffer verwendet wird.

7. Verfahren nach einem der Ansprüche 1 bis 6, **dadurch gekennzeichnet, daß** jeder Zeiger aus dem Code der betreffenden Speicherplatz-Nummer und der dazugehörige Prüfwert aus dem Komplement-Code dieser Speicherplatz-Nummer besteht.

8. Ringspeicher mit einer vorgegebenen Anzahl von Speicherplätzen (R1, ... Rn), die jeweils einen Datensatz (D#1, ...) aufnehmen, und einem Zeiger-Speicherplatz, in den ein Zeiger eingeschrieben wird, der auf denjenigen Speicherplatz zeigt, der den jeweils aktuellen Datensatz (D#2) enthält, **dadurch gekennzeichnet, daß** ein erster Zeigerspeicherplatz (RP1) für einen ersten Zeiger (P1, P1*) einschließlich eines Prüfwerts (P1*) und ein zweiter Zeiger-Speicherplatz (RP2) für einen zweiten, zu dem ersten Zeiger redundanten Zeiger (P2, P2*) einschließlich eines Prüfwerts (P2*) vorgesehen sind.

9. Ringspeicher nach Anspruch 8 zur Verwendung in einem Verfahren nach einem der Ansprüche 1 bis 7.

10. Chipkarte mit einem Ringspeicher nach Anspruch 8 oder 9.

## Claims

1. A method for safe writing of a pointer (P) for records contained in individual memory locations (*R*1, *R*2, ...) of a ring memory (10; 10') comprising the steps of
a) writing, in addition to a first pointer (*P*1, *P*1 *), a second pointer (*P*2, *P*2*) redundant with respect to the first pointer; and
b) expanding both the first and the second pointer by a check value.

2. A method according to claim 1, **characterized in that** the first pointer (*P*1, *P*1 *) and the second pointer (*P*2, *P*2*) are written separately from each other, in particular staggered in time.

3. A method according to claim 1 or 2, **characterized in that** a determination or check of the current pointer comprises the following steps:
a) checking the first pointer (*P*1) using the check value (*P*1*) (*S*2),
b) comparing the first pointer with the second pointer (*S*3) if the first pointer (*P*1) is correct,
c) copying the first pointer to obtain the new second pointer upon a mismatch of the two pointers during the comparison according to step b),
d) checking the second pointer (P2) using the check value (*P*2*) (*S*6) if the first pointer (*P*1) is not correct,
e) overwriting the first pointer (*P*1, *P*1*) with the value of the pointer (P2, *P*2*) (*S*7) if the second pointer is correct according to d).

4. A method for managing a ring memory (10; 10') using the method according to any of claims 1 to 3, **characterized in that** for writing a new record (*D*'#3) to a predetermined memory location *(R3)* which cyclically follows the memory location (*R*2) designated by the pointer (*P*), the new record is written to the predetermined memory location (*R*3) and then an updated pointer is written.

5. A method according to claim 4, **characterized in that** before the new record (*D*'#3) is written to the predetermined memory cell the content of said cell is erased.

6. A method according to claim 4 or 5, **characterized in that** the predetermined memory location contains the oldest record in the ring memory (10') and is used as a write buffer.

7. A method according to any of claims 1 to 6, **characterized in that** each pointer consists of the code of the relevant memory location number, and the corresponding check value of the complement code of said memory location number.

8. A ring memory having a predetermined number of memory locations (*R*1, ... *Rn*) each receiving one record (D#1, ...), and a pointer memory location to which a pointer is written which points to that memory location containing the current record (D#2), **characterized in that** it includes a first pointer memory location (*RP*1) for a first pointer (*P*1, *P*1*) including a check value (*P*1*), and a second pointer memory location (*RP*2) for a second pointer (P2, *P*2*) redundant with respect to the first pointer and including a check value (*P*2*).

9. A ring memory according to claim 8 for use in a method according to any of claims 1 to 7.

10. A smart card having a ring memory according to claim 8 or 9.

## Revendications

1. Procédé pour l'écriture sûre d'un pointeur (P) pour des phrases de données contenues dans des emplacements de mémoire (R1, R2, ...) individuels d'une mémoire circulaire (10 ; 10'), pour lequel
a) en plus d'un premier pointeur (P1, P1*), un second pointeur (P2, P2*) redondant au premier pointeur est écrit; et
b) le premier tout comme le second pointeur sont étendus autour d'une valeur de contrôle.

2. Procédé selon la revendication 1, **caractérisé en ce que** le premier pointeur (P1, P1*) et le second pointeur (P2, P2*) sont écrits séparément l'un de l'autre, et notamment de manière échelonnée dans le temps.

3. Procédé selon la revendication 1 ou 2, **caractérisé en ce qu'**une détermination et/ou vérification du pointeur actuel comprend les étapes suivantes :
a) vérification du premier pointeur (P1) à l'aide de la valeur de contrôle (P1*)(S2),
b) comparaison du premier pointeur avec le second pointeur (S3), lorsque le premier pointeur (P1) est correct,
c) en cas de non-concordance des deux pointeurs lors de la comparaison selon l'étape b), le premier pointeur est copié afin d'obtenir le nouveau second pointeur,
d) vérification du second pointeur (P2) à l'aide de la valeur de contrôle (P2*) (S6) si le premier pointeur (P1) n'est pas correct,
e) écrasement du premier pointeur (P1, P1*) avec la valeur du pointeur (P2, P2*) (S7) si le second pointeur est correct selon d).

4. Procédé pour la gestion d'une mémoire circulaire (10 ; 10') en utilisant le procédé selon l'une des revendications 1 à 3, **caractérisé en ce que**, pour écrire une nouvelle phrase de données (D'#3) dans un emplacement de mémoire prédéfini (R3) qui est adjacent de façon cyclique à l'emplacement mémoire (R2) désigné par le pointeur (P), la nouvelle phrase de données est inscrite dans l'emplacement mémoire prédéfini (R3) et un pointeur actualisé est ensuite écrit.

5. Procédé selon la revendication 4, **caractérisé en ce que**, avant l'inscription de la nouvelle phrase de données (D'#3) dans la cellule de mémoire prédéfinie, son contenu est effacé.

6. Procédé selon la revendication 4 ou 5, **caractérisé en ce que** l'emplacement de mémoire prédéfini contient la plus ancienne phrase de données dans la mémoire circulaire (10') et est utilisé en tant que tampon d'écriture.

7. Procédé selon l'une des revendications 1 à 6, **caractérisé en ce que** chaque pointeur se compose du code du numéro d'emplacement mémoire correspondant et **en ce que** la valeur de contrôle associée est constituée du code complémentaire de ce numéro d'emplacement de mémoire.

8. Mémoire circulaire avec une quantité prédéfinie d'emplacements mémoire (R1,... Rn) qui acceptent chacun une phrase de données (D#1, ...), et un emplacement de mémoire pour le pointeur, dans lequel un pointeur est inscrit, qui pointe sur l'emplacement mémoire contenant la phrase de données actuelle (D#2) respectivement, **caractérisée en ce qu'**un premier emplacement mémoire de pointeur (RP1) est prévu pour un premier pointeur (P1, P1*) comprenant une valeur de contrôle (P1*), et un second emplacement mémoire de pointeur (RP2) pour un second pointeur redondant au premier pointeur (P2, P2*) comprenant une valeur de contrôle (P2*).

9. Mémoire circulaire selon la revendication 8 pour être utilisée dans un procédé selon l'une des revendications 1 à 7.

10. Carte à puces avec une mémoire circulaire selon la revendication 8 ou 9.
